**Europäisches Patentamt**

**European Patent Office**

**Office européen des brevets**

(19)

(11) Veröffentlichungsnummer: **0 051 315**
**B1**

(12) **EUROPÄISCHE PATENTSCHRIFT**

(45) Veröffentlichungstag der Patentschrift:
**13.05.87**

(51) Int. Cl.⁴: **H 01 L 23/46**, H 01 L 25/10,
H 05 K 7/20

(21) Anmeldenummer: **81109487.9**

(22) Anmeldetag: **03.11.81**

(54) **Halbleiter-Schaltungsaufbau.**

(30) Priorität: **05.11.80 DE 3041656**

(43) Veröffentlichungstag der Anmeldung:
**12.05.82 Patentblatt 82/19**

(45) Bekanntmachung des Hinweises auf die Patenterteilung:
**13.05.87 Patentblatt 87/20**

(84) Benannte Vertragsstaaten:
**AT CH FR GB IT LI**

(56) Entgegenhaltungen:
**DE - A - 1 939 803**
**DE - A - 2 008 800**
**DE - A - 2 205 429**
**DE - A - 2 718 967**
**DE - B - 2 611 260**
**DE - U - 7 635 405**

(73) Patentinhaber: **SEMIKRON Elektronik GmbH,
Sigmundstrasse 200, D-8500 Nürnberg 82 (DE)**

(72) Erfinder: **Brehm, Heinz, Kachletstrasse 43,
D-8500 Nürnberg (DE)**
Erfinder: **Weigand, Adolf, Waldstrasse 30,
D-8501 Rückersdorf (DE)**

ACTORUM AG

## Beschreibung

Die Erfindung betrifft einen Halbleiter-Schaltungsaufbau nach dem Oberbegriff des Anspruchs 1.

Ein derartiger Halbleiter-Schaltungsaufbau ist aus der DE-A-2 718 967 bekannt.

Aus der Zeitschrift «Elektrotechnik» 58, H. 3, 1976 ist ein Halbleiter-Schaltungsaufbau bekannt, bei dem als Modul bezeichnete Baueinheiten aus zwei Halbleiterbauelementen achsenparallel auf einem, im Strangpressverfahren hergestellten Kühlbauteil sowie eine mit Beschaltungsbauteilen für die Baueinheiten bestückte Isolierstoffplatte an einer der mit Rippen versehenen Seiten des Kühlbauteils befestigt sind. Direkt am Kühlbauteil ist ein für dessen Querschnitt bemessener Lüfter angebracht. Bei solchen Anordnungen kann gerade die räumliche Zuordnung der Beschaltungsbauteile Schwierigkeiten bereiten. Ferner weisen sie ein unerwünscht hohes Lüftergeräusch auf. Ausserdem sind die Baueinheiten nicht optimal gekühlt, und die Stromanschlüsse der Baueinheiten sowie die damit verbundenen Stromleiter können durch mechanische Beanspruchung in ihrer räumlichen Lage ungünstig verändert werden.

Weiter ist aus der DE-AS 2 611 260 ein Halbleiter-Schaltungsaufbau bekannt, bei welchem Kühlbauteil, Lüfter und Halbleiterbaueinheiten wie vorbeschrieben angeordnet und auf weiteren Schaltungsebenen, die durch starre Leitungselemente auf den Stromanschlüssen der Baueinheiten gebildet sind, Schaltungsbauteile angebracht sind. Bei diesen Bauformen kann zu den vorgenannten Nachteilen eine unerwünschte gegenseitige Erwärmung der Baueinheiten und der Schaltungsbauteile auftreten. Ferner ist der Austausch und/oder die Wartung der Baueinheiten aufwendig.

Ferner ist aus der DE-A-2 205 429 ein Stromrichterschrank mit nebeneinander angeordneten U-Profilkästen als Luftführungsschächte sowie in den Profilkästen angeordnete, mit Gleichrichterelementen bestückte Kühlkörper bekannt. Letztere sind als schnell auswechselbare Baueinheiten ausgebildet. An den Frontseiten der Kühlkörper sind die Gleichrichterelemente und alle zu deren Betrieb erforderlichen zusätzlichen Bauteile und Funktionselemente angebracht.

Um die Verwendung von scheibenzellenförmigen Gleichrichterelementen zu ermöglichen, sind die Kühlkörper zweigeteilt und die Scheibenzellen zwischen die Teilkühlkörper eingespannt, wobei Blenden innerhalb der Profilkästen derart angeordnet sind, dass der Kühlluftstrom nicht über die Gleichrichterelemente strömt.

Der Erfindung liegt die Aufgabe zugrunde, einen Halbleiter-Schaltungsaufbau mit Halbleiterbaueinheiten, die gegen eine gemeinsame Grundplatte elektrisch isolierte Halbleiterbauelemente enthalten, für Fremdbelüftung zu schaffen, der eine wirtschaftlichere und kompakte Struktur, geringeres Lüftergeräusch und bestmögliche Belüftung aller Verlustwärme erzeugenden Bauteile aufweist, und bei welchem die Stromanschlüsse der Halbleiterbaueinheiten und die damit verbundenen Stromleiter gegen eine Veränderung ihrer räumlichen Lage aufgrund unzulässiger mechanischer Beanspruchung gesichert sind.

Die Lösung der Aufgabe besteht bei einem Halbleiter-Schaltungsaufbau der eingangs genannten Art in den kennzeichnenden Merkmalen des Anspruchs 1.

Vorteilhafte Ausgestaltungen des Gegenstandes der Erfindung sind in den Ansprüchen 2–15 gekennzeichnet.

Die Vorteile des erfindungsgemässen Halbleiter-Schaltungsaufbaus bestehen in der besonders wirtschaftlichen Gestaltung der zur Anordnung der Halbleiterbaueinheiten dienenden Zubehörteile, in dem einfachen Zusammenbau sämtlicher Bauteile und in der verbesserten Kühlluftverteilung sowie darin, dass sämtliche Schaltungsbauteile leicht zugänglich sind und dass ohne mechanische Beanspruchung der Stromanschlüsse der Halbleiterbaueinheiten an deren Stromleitern beliebige feste Verbindungen herstellbar sind.

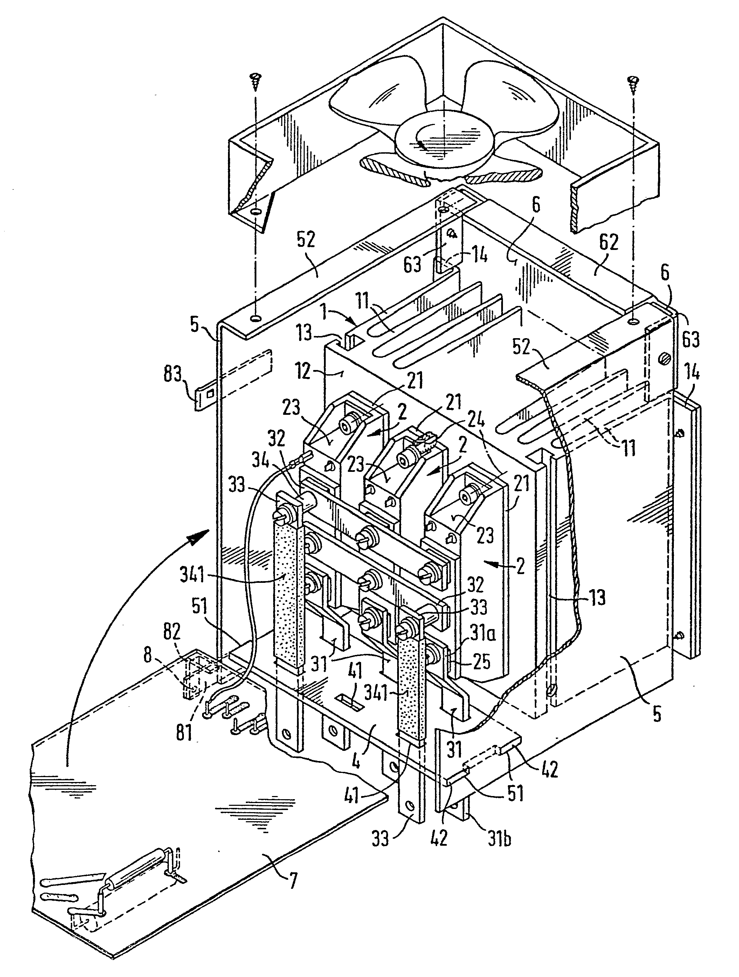

Anhand des Ausführungsbeispiels in der Figur, die in perspektivischer Ansicht die gegenseitige räumliche Zuordnung von Halbleiterbauelementen, Kühlbauteil, weiteren Schaltungselementen und Stromleitern in einem Kühlluftkanal zeigt, wird der Gegenstand der Erfindung aufgezeigt und erläutert.

Das Kühlbauteil 1, beispielsweise aus einer Leichtmetallegierung und im Strangpressverfahren hergestellt, weist eine Montageplatte 12 und Kühlrippen 11 auf, welche an einer Seite der Montageplatte senkrecht zu dieser und gegenseitig parallel angeordnet sind, und wovon nur die beiden äusseren Kühlrippen dargestellt sind. Die grossflächige, plane Oberseite der Montageplatte 12 weist je zwei Bohrungen 14 für die Befestigung von drei Halbleiterbaueinheiten 2 mit ihrer Grundplatte 21 in achsparalleler Anordnung und in Strömungsrichtung auf. Dazu dient jeweils eine Durchbohrung 24 an einer Aussparung 23 an jeder Stirnseite der Baueinheiten.

Die Baueinheiten 2 sind so angeordnet, dass jeweils der Wechselstromanschluss der drei in Reihe liegenden Stromanschlüsse an der vom Lüfter abgewandten Stirnseite jeder Baueinheit liegt. Auf diesem äussersten der Stromanschlüsse 25 ist ein Stromleiter 31 befestigt. Die Stromleiter 31 dienen als Wechselstromzuführungen und verlaufen vorzugsweise parallel und in Längsrichtung der Baueinheiten. Die beiden weiteren Stromanschlüsse der Baueinheiten sind jeweils durch eine quer zu den Stromleitern 31 angeordnete Kontaktschiene 32 verbunden und bilden die Gleichstromanschlüsse der Schaltungsanordnung. Für die vorgesehene Schaltung der Baueinheiten 2 ist jede quer verlaufende Kontaktschiene 32 über ein metallisches Distanzstück 34 mit einem parallel zu den Stromleitern 31 angeordneten Stromleiter 33 fest verbunden. Gemäss der Darstellung sind die beiden Stromleiter 33 den beiden äusseren Baueinheiten zugeordnet.

Der elektrische Anschluss der Baueinheiten über deren Stromleiter 31, 33 erfolgt daher im wesentlichen im Bereich der Baueinheitenebene auf der mit den Baueinheiten versehenen Seite des Kühlbauteils 1 und an dessen vom Lüfter abgewandten Ende.

Zur Erzielung der notwendigen Luftisolationsabstände zwischen den Stromleitern 31, 33 können zusätzlich zu den Distanzstücken 34 die Stromleiter 31 in entsprechender Weise gekröpft ausgebildet sein, wobei gemäss der Darstellung der kurze Längenabschnitt 31a dem Stromanschluss 25 einer Baueinheit 2 zugeordnet ist und im Anschluss an die Kröpfung der längere Abschnitt 31b den erforderlichen Abstand zu den Stromleitern 33 aufweist.

Zur optimalen Ableitung der Verlustwärme gemäss der Aufgabenstellung sind die Baueinheiten 2 ebenfalls direkt der Luftkühlung ausgesetzt. Der Kühlluftkanal besteht zu diesem Zweck aus zwei Zonen, wovon die eine Zone durch den Querschnitt des Kühlbauteils 1 und die andere Zone durch den für die Baueinheiten 2 und deren Stromleiter vorgesehenen Raum bestimmt ist. Bei entsprechender Ausbildung des Kühlluftkanals vom Ende der Kühlrippen 11 in Richtung der Montageplatte 12 des Kühlbauteils 1 und weiter in einer Erstreckung bis über die Stromleiter 33 hinaus wird, entsprechend dem unterschiedlichen Luftwiderstand in den beiden Zonen, zwischen den Kühlrippen der geringere Anteil und im Bereich der Baueinheiten 2 der grössere Anteil des gesamten, durch den Lüfter erzeugten Kühlluftstromes entstehen.

Um diese unerwünschte Verteilung zu verhindern und die überwiegende Kühlung in der Zone des Kühlbauteils 1 zu erreichen, ist die den Baueinheiten zugeordnete Zone des Kühlluftkanals am freien Ende des Kühlbauteils 1 wenigstens teilweise durch eine Luftstauplatte 4 verschlossen. Diese ist im wesentlichen senkrecht zur Montageplatte 12 und zur Strömungsrichtung der Kühlluft sowie im Abstand zur Montageplatte 12 angebracht. Der dadurch gebildete Luftspalt gewährleistet die direkte Luftkühlung der Halbleiterbaueinheiten 2. Bei sonst gleichen Betriebsbedingungen wird durch Wahl der Luftspaltbreite der Anteil des Kühlluftstromes für die Baueinheiten 2 bestimmt. Das heisst, die Flächenausdehnung der Luftstauplatte 4 wird durch Vorgabe des Luftspalts festgelegt. Einen Anhaltspunkt für die anteilige Belüftung der Baueinheiten 2 liefert das Verhältnis der Luftspaltfläche zur Luftdurchtrittsfläche im Kühlbauteil 1.

Die Luftstauplatte 4 weist schlitzförmige Öffnungen 41 auf, deren Querschnitt dem Querschnitt der Stromleiter 31 bzw. 33 entspricht, und die zur festen und gegen räumliche Veränderung gesicherten Anordnung der Stromleiter dienen. Entsprechend sind für den Verlauf der Stromleiter 31 für die Wechselstromanschlüsse drei Öffnungen 41 in einer ersten Ebene nebeneinander und für den Verlauf der Stromleiter 33 für die Gleichstromanschlüsse weitere Öffnungen 41 in einer zweiten, darüberliegenden Ebene angeordnet. Die Abstände der Öffnungen 41 und damit der Stromleiter sind durch die Forderung nach ausreichender Überschlagsfestigkeit in Luft zwischen stromführenden Leiterteilen oder deren Zubehör bestimmt. Die Öffnungen 41 sind ausserdem spiegelbildlich zur Längs- und zur Querachse der Stauplatte 4 angeordnet, was sich beim Einbau der letzteren als besonders vorteilhaft erweist.

Der Kühlluftkanal besteht aus zwei Seitenwänden 5, die je mit einer äusseren Kühlrippe 11 des Kühlbauteils 1 verbunden sind, aus einer Bodenplatte 6, die das Kühlbauteil 1 am Ende der Kühlrippe 11 abdeckt, und aus der Schaltungsplatte 7, welche die für die Halbleiterbaueinheiten 2 vorgesehene, durch die Seitenwände 5 und die Deckplatte 12 begrenzte zweite Zone abschliesst.

Die Länge des Kühlluftkanals ist durch die Länge des Kühlbauteils 1 und durch den zwischen diesem und dem Lüfter vorgesehenen Abstand bestimmt. Durch diese räumlichen Massgaben sind die Flächenmasse der Teile des Kühlluftkanals im wesentlichen festgelegt.

Zur festen Verbindung der Luftstauplatte 4, am freien Ende des Kühlluftkanals etwa über der Querkante des Kühlbauteils 1, mit den Seitenwänden 5 sind diese in der entsprechenden Randzone mit wenigstens einer schlitzförmigen Aussparung 51 versehen, in welche ein entsprechend angepasster, stirnseitiger ebener Fortsatz 42 der Luftstauplatte 4 eingreift. Zur Vereinfachung des Zusammenbaus der Bauteile 4 und 5 sind die Seitenwände jeweils in der ganzen Länge ihrer Randzone an entsprechenden Stellen mit Aussparungen 51 versehen. Dadurch sind sie vertauschbar, und die Lagerhaltung wird vereinfacht.

Anstelle der angegebenen Steckverbindung der Bauteile 4 und 5 kann beispielsweise auch eine Schraubverbindung vorgesehen sein.

Die Seitenwände 5 sind am Kühlbauteil 1 jeweils in einer Längsnut 13 unterhalb der Längskante der Montageplatte 12 befestigt und weisen zur Herstellung einer Schraubverbindung an entsprechenden Stellen Durchbohrungen auf. Das Kühlbauteil 1 und der Kühlluftkanal sind so bemessen, dass die Längsnut 13 bei der vorgesehenen Anordnung der Seitenwände 5 koaxial mit der Längsachse der Seitenwände verläuft. Diese Massgabe vereinfacht den Zusammenbau ebenfalls in besonders vorteilhafter Weise. Die gegenseitige räumliche Zuordnung der Seitenwände zum Kühlbauteil ist lediglich durch die Forderung bestimmt, dass die Seitenwände wegen einer geeigneten mechanischen Verbindung mit der Bodenplatte 6 annähernd bis zum freien Ende der Kühlrippen 11 verlaufen.

Bei dem dargestellten Ausführungsbeispiel weist das Kühlbauteil 1 an den äusseren Kühlrippen 11 je einen für eine Flanschverbindung vorgesehenen Ansatz 14 zu gewünschten Systembefestigungen auf. Die Seitenwände 5 können dann so bemessen sein, dass sie mit ihrer Längskante auf dem Ansatz 14 aufsitzen.

Die Bodenplatte 6 bildet den Verschluss für die durch die Kühlrippen 11 begrenzte Zone des Kühlluftkanals. Mit den Seitenwänden 5 ist die Bodenplatte gemäss der Darstellung mit Hilfe abgewinkelter Ansätze 63, die jeweils im Anschluss an das Kühlbauteil 1 angebracht sind, fest verbunden.

Bei einem Kühlbauteil ohne den Ansatz 14 kann die gegenseitige Verbindung von Bodenplatte und Seitenwänden mit Hilfe von je einem durchgehenden Winkelansatz 64 erfolgen. Die Art der Befestigung dieser Bauteile ist nicht Gegenstand der Erfindung.

Weiterhin weisen Bodenplatte 6 und Seitenwände 5 an den zur Anordnung des Lüfters vorgesehenen Seiten je einen Winkelansatz 62 bzw. 52 zur Anbringung des Lüfters auf.

Als Material für die Seitenwände 5 und für die Bodenplatte 6 sind bedarfsweise oberflächenbehandelte Bleche vorgesehen. Damit ist der Vorteil verbunden, dass Schraubverbindungen durch selbstschneidende Schrauben herstellbar sind.

Die der Bodenplatte 6 gegenüberliegende Schaltungsplatte 7 bildet zwischen Lüfter und Luftstauplatte 4 eine Seitenwand des Kühlluftkanals. Sie ist an einer ihrer Seitenkanten mit Hilfe eines Drehgelenks mit einer oder mit beiden Seitenwänden 5 beweglich befestigt. Dadurch ist die zweite Zone, in welcher die Halbleiterbaueinheiten und die zugehörigen Schaltungsbauteile angeordnet sind, für Wartungsarbeiten sowie für zusätzliche Schaltungsmassnahmen leicht zugänglich. Gemäss der Darstellung ist die Schaltungsplatte 7 längs einer Schmalseite aufklappbar angebracht. Das dazu verwendete Scharnier 8 besteht aus zwei Hälften mit je einem gestreckten Gelenkteil 81 und einem winkelförmigen Gelenkteil 82. Die Gelenkteile jeder Hälfte sind drehbar miteinander verbunden, und jedes Gelenkteil 81 ist an einer Seitenwand 5 und jedes Gelenkteil 82 ist an entsprechender Stelle des Schaltungsplatte 7 befestigt. Zur festen Anlage jeder Längskante des Schaltungsplatte 7 an der entsprechenden Längskante der Seitenwand 5 dient je eine Federklammer 83.

Die Schaltungsplatte 7 weist an ihrer Innenseite sämtliche für die Leitungsführung von Schaltungsbauteilen zu einer äusseren Klemmleiste erforderliche Leiterbahnen auf sowie die nötigen Schaltungswiderstände und auf der Aussenseite die Schaltungskondensatoren. Die entsprechenden Steuerleitungen sind flexibel ausgeführt.

Weitere Befestigungsmöglichkeiten für die Schaltungsplatte 7 bestehen in einer Schraubverbindung mit einem entsprechenden Winkelansatz der Seitenwände 5 oder aber in Schnellverschlüssen, wie sie als sogenannte Bajonettverschlüsse, Drehverschlüsse, Feststeller und andere im Handel erhältlich sind. Die Verbindung der Schaltungsplatte 7 mit den Seitenwänden 5 ist nicht Gegenstand der Erfindung.

Die Schaltungsplatte 7 kann auf ihrer Aussenseite weitere zusätzliche Schaltungsebenen aufweisen, welche beispielsweise mit Hilfe von starren Tragbolzen zur Anbringung weiterer Kunststoffplatten als Schaltungsträger oder von Schaltungsbauteilen hergestellt sind.

Zur Erleichterung der elektrischen Funktionsprüfung von Schaltungsteilen kann die Schaltungsplatte 7 zusätzlich sie durchstossende Kontaktbolzen aufweisen, welche auf der Innenseite mit wesentlichen Anschlusspunkten der Schaltung verbunden sind.

Bei einem anderen Ausführungsbeispiel des Gegenstandes der Erfindung kann anstelle der Seitenwände 5 und der Bodenplatte 6 des Kühlluftkanals lediglich ein U-profilförmiges Bauteil vorgesehen sein. Dessen gegenüberliegende Seitenwände sind dann zur Befestigung des Lüfters an dem vorgesehenen Ende mit U-förmigen Laschen verbunden, auf welche der Lüfter aufgesetzt ist. Zur Systembefestigung ist die als Bodenfläche vorgesehene Seite des Bauteils im Bereich zwischen Lüfter und Kühlbauteil 1 mit entsprechenden Öffnungen versehen.

Bei einem weiteren Ausführungsbeispiel des Gegenstandes der Erfindung können die Seitenwände 5 und die Bodenplatte 6 Teile des Kühlbauteils 1 sein. Die Kühlrippen 11 erstrecken sich zu diesem Zweck in entsprechender Ausdehnung über die Montageplatte 12 hinaus zur Begrenzung der für die Baueinheiten 2 vorgesehenen Zone, ferner über die Länge des Kühlbauteils 1 hinaus zur Bildung eines freien Raumes zwischen Lüfter und Kühlbauteil 1 und schliesslich unterhalb der inneren Kühlrippen bis zur gegenseitigen Verbindung.

**Patentansprüche**

1. Halbleiter-Schaltungsaufbau, bei dem wenigstens eine Halbleiterbaueinheit (2) mit gegen die Grundplatte der Baueinheit elektrisch isoliert befestigten Halbleiterelementen auf der Montageplatte (12) eines Kühlbauteils (1) und mit diesem in einem das Kühlbauteil umschliessenden und mit einem Lüfter verbundenen Kühlluftkanal angeordnet ist, bei dem in einer ersten Zone des Kühlluftkanals (1) und in einer zweiten Zone im wesentlichen die auf dem Kühlbauteil befestigte Halbleiterbaueinheit (2) mit ihren Stromleitern (31, 33) umschlossen sind, und bei dem als Seitenwand der zweiten Zone des Kühlluftkanals eine Schaltungsplatte (7) vorgesehen ist, auf welcher zusätzliche Schaltungselemente für die Halbleiterbaueinheit (2) angebracht sind, dadurch gekennzeichnet, dass in der zweiten Zone des Kühlluftkanals am freien Ende des Kühlbauteils (1) eine Luftstauplatte (4) im wesentlichen senkrecht und im Abstand zur Montageplatte (12) angeordnet ist, dass der Luftspalt zwischen Luftstauplatte (4) und Montageplatte (12) durch den zur Kühlung der Halbleiterbaueinheit (2) erforderlichen Luftstrom bestimmt ist, und dass die Schaltungsplatte (7) zum Öffnen der zweiten Zone umklappbar angebracht ist.

2. Halbleiter-Schaltungsaufbau nach Anspruch 1, dadurch gekennzeichnet, dass die Luftstauplatte (4) an gegenüberliegenden Seitenwänden (5) der zweiten Zone befestigt ist.

3. Halbleiter-Schaltungsaufbau nach Anspruch 2, dadurch gekennzeichnet, dass die Schmalseiten der Luftstauplatte (4) Fortsätze (42) und die jeweils zugeordnete Randzone der Seitenwände (5) angepasste Aussparungen (51) zum Eingriff der Fortsätze (42) aufweisen.

4. Halbleiter-Schaltungsaufbau nach Anspruch 1, dadurch gekennzeichnet, dass die Luftstauplatte (4) gleichzeitig zur Halterung der Stromleiter (31, 33) der Halbleiterbaueinheit (2) vorgesehen ist und Öffnungen (41) zur Durchführung derselben aufweist.

5. Halbleiter-Schaltungsaufbau nach einem der Ansprüche 1 bis 4, dadurch gekennzeichnet, dass das Kühlbauteil (1) aus der Montageplatte (12) und aus parallelen, an einer Seite der Montageplatte (12) angebrachten Kühlrippen (11) besteht.

6. Halbleiter-Schaltungsaufbau nach einem der Ansprüche 1 bis 4, dadurch gekennzeichnet, dass das Kühlbauteil (1) aus der Montageplatte (12) und aus parallelen, an beiden Seiten der Montageplatte (12) angebrachten Kühlrippen besteht.

7. Halbleiter-Schaltungsaufbau nach Anspruch 6, dadurch gekennzeichnet, dass die äusseren Kühlrippen (11) des Kühlbauteils (1) gleichzeitig als Seitenwände des Kühlluftkanals ausgebildet sind.

8. Halbleiter-Schaltungsaufbau nach einem der Ansprüche 1 bis 7, dadurch gekennzeichnet, dass das Kühlbauteil (1) am Ende jeder äusseren Kühlrippe (11) je einen flanschförmigen Ansatz (14) aufweist.

9. Halbleiter-Schaltungsaufbau nach Anspruch 1 oder einem der folgenden Ansprüche, dadurch gekennzeichnet, dass die Schaltungsplatte (7) mit Hilfe eines Drehgelenks (8) mit einer oder mit beiden Seitenwänden (5) beweglich verbunden ist und an wenigstens einer Seite mit Hilfe von Federklammern an der zugeordneten Seitenwand (5) fest anliegt.

10. Halbleiter-Schaltungsaufbau nach Anspruch 1 oder einem der folgenden Ansprüche, dadurch gekennzeichnet, dass die Schaltungsplatte (7) durch Verschraubung mit der entsprechend ausgebildeten Randzone (52) jeder Seitenwand (5) fest verbunden ist.

11. Halbleiter-Schaltungsaufbau nach Anspruch 1 oder einem der folgenden Ansprüche, dadurch gekennzeichnet, dass die Schaltungsplatte (7) mit Hilfe von an sich bekannten Schnellverschlüssen, wie Bajonettverschlüssen, Drehverschlüssen, Feststellern oder ähnlichem, mit den Seitenwänden (5) fest verbunden ist.

12. Halbleiter-Schaltungsaufbau nach einem der vorhergehenden Ansprüche, dadurch gekennzeichnet, dass die Schaltungsplatte (7) an ihrer Innenseite alle für die Leitungsführung und Schaltung zusätzlicher Schaltelemente erforderlichen Leiterbahnen aufweist.

13. Halbleiter-Schaltungsaufbau nach einem der vorhergehenden Ansprüche, dadurch gekennzeichnet, dass sämtliche Verlustwärme erzeugenden Schaltungselemente an der Innenseite der Schaltungsplatte (7) angeordnet sind.

14. Halbleiter-Schaltungsaufbau nach einem der vorhergehenden Ansprüche, dadurch gekennzeichnet, dass die Schaltungsplatte (7) zur erleichterten Funktionsprüfung von Schaltungselementen mit die Schaltungsplatte (7) durchstossenden Kontaktbolzen versehen ist, die an ihrer Innenseite mit funktionswesentlichen Anschlussstellen der Halbleiterschaltung verbunden sind.

15. Halbleiter-Schaltungsaufbau nach einem der vorhergehenden Ansprüche, dadurch gekennzeichnet, dass die Schaltungsplatte (7) zur Anordnung von weiteren Schaltungsbauteilen auf wenigstens einer über der Schaltungsplatte vorgesehenen Schaltungsebene geeignet ausgebildet ist.

**Claims**

1. Semiconductor circuit structure in which at least one semiconductor unit (2) is arranged with semiconductor elements secured electrically insulated with respect to the base plate of the unit on the mounting plate (12) of a cooling component (1) and with the latter in a cooling air passage surrounding the cooling component and connected to a fan, wherein in a first zone of the cooling air passage the cooling component (1) and in a second zone substantially the semiconductor unit (3) secured on the cooling component with its leads (31, 33) are enclosed and as side wall of the second zone of the cooling air passage a circuit board (7) is provided on which additional circuit elements for the semiconductor unit (2) are disposed, characterized in that in the second zone of the cooling air passage at the free end of the cooling component (1) an air dam plate (4) is arranged substantially perpendicularly and in spaced relationship to the mounting plate (12), that the air gap between the air dam plate (4) and mounting plate (12) is defined by the air flow necessary for cooling the semiconductor unit (2) and that the circuit board (7) is arranged pivotally for opening the second zone.

2. Semiconductor circuit structure according to claim 1, characterized in that the air dam plate (1) is secured at opposite side walls (5) of the second zone.

3. Semiconductor circuit structure according to claim 2, characterized in that the narrow sides of the air dam plate (4) have extensions (42) and the respective associated edge zone of the side walls (5) adapted recesses (51) for engagement of the extensions (42).

4. Semiconductor circuit structure according to claim 1, characterized in that the air dam plate (4) is provided simultaneously for holding the leads (31, 33) of the semiconductor unit (2) and has openings (41) for the passage thereof.

5. Semiconductor circuit structure according to any one of claims 1 to 4, characterized in that the cooling component (1) consists of the mounting plate (12) and parallel cooling ribs (11) disposed on one side of the mounting plate (12).

6. Semiconductor circuit structure according to any one of claims 1 to 4, characterized in that the cooling component (1) consists of the mounting plate (12) and parallel cooling ribs disposed on both sides of the mounting plate (12).

7. Semiconductor circuit structure according to claim 6, characterized in that the outer cooling ribs (11) of the cooling component (1) are formed simultaneously as side walls of the cooling air passage.

8. Semiconductor circuit structure according to any one of claims 1 to 7, characterized in that the cooling component (1) comprises a flange-like extension (14) at the end of each outer cooling rib (11).

9. Semiconductor circuit structure according to claim 1 or any of the following claims, characterized in that the circuit board (7) is connected movably with the aid of a hinge joint (8) to one or both side walls (5) and bears on at least one side firmly with the aid of spring clips on the associated side wall (5).

10. Semiconductor circuit structure according to claim 1 or one of the following claims, characterized in that the circuit board (7) is fixedly connected by screwing to the correspondingly formed edge zone (52) of each side wall (5).

11. Semiconductor circuit structure according to claim 1 or one of the following claims, characterized in that the circuit board (7) is fixedly connected to the side walls (5) with the aid of quick-action fasteners known per se, such as bayonet fasteners, rotary fasteners, lock means or the like.

12. Semiconductor circuit structure according to any one of the preceding claims, characterized in that the circuit board (7) comprises at its inner side all conductor paths necessary for the conduction routing and connecting of additional circuit elements.

13. Semiconductor circuit structure according to any one of the preceding claims, characterized in that all circuit elements generating dissipated heat are disposed on the inner side of the circuit board (7).

14. Semiconductor circuit structure according to any one of the preceding claims, characterized in that the circuit board (7) for facilitating the function checking of circuit elements is provided with contact pins which penetrate through the circuit board (7) and at their inner side are connected to functionally essential connection of the semiconductor circuit.

15. Semiconductor circuit structure according to any one of the preceding claims, characterized in that the circuit board (7) is constructed for arrangement of further circuit components on at least one circuit plane provided above the circuit board.

## Revendications

1. Ensemble intégré de semiconducteurs et circuits où au moins une unité de semiconducteurs (2) est disposée sur une platine de montage d'un dissipateur de chaleur, avec ses éléments constitutifs semiconducteurs fixés sur le support plan de l'unité et isolés électriquement, l'unité de semiconducteurs et le dissipateur de chaleur sont disposés dans un canal d'air frais les entourant et en prise avec un ventilateur, le dissipateur de chaleur (1) est disposé dans une première zone du canal d'air frais, l'unité de semiconducteurs (2) avec ses conducteurs électriques (31, 32) étant disposée dans une seconde zone dudit canal d'air frais, la paroi latérale de la seconde zone du canal d'air frais est constituée par une plaquette à circuits imprimés (7) sur laquelle sont disposés des éléments de circuits complémentaires à l'unité de semiconducteurs (2), caractérisé en ce que une plaque-chicane (4) de l'air est disposée à l'extrémité libre de la seconde zone du canal d'air frais, perpendiculairement à la platine de montage (12) du dissipateur de chaleur et à une certaine distance de celle-ci, la fente d'aération comprise entre la plaque-chicane (4) de l'air et la platine de montage (12) est déterminée par le courant d'air nécessaire au refroidissement de l'unité de semiconducteurs (2), la plaquette à circuits imprimés (7) peut pivoter pour permettre l'ouverture de la seconde zone du canal d'air frais.

2. Ensemble selon la revendication 1, caractérisé en ce que la plaque-chicane (4) de l'air est assemblée avec les parois latérales (5) se faisant face de la seconde zone du canal d'air frais.

3. Ensemble selon la revendication 2, caractérisé en ce que les petits chants de la plaque-chicane (4) de l'air comportent des tétons (42) qui s'engagent dans des fentes correspondantes (51) prévues près du bord des parois latérales (5).

4. Ensemble selon la revendication 1, caractérisé en ce que la plaque-chicane (4) de l'air sert simultanément à maintenir les conducteurs électriques (31, 33) de l'unité de semiconducteurs et comporte à cette fin des ouvertures (41) pour permettre le passage desdits conducteurs électriques.

5. Ensemble selon l'une des revendications 1 à 4, caractérisé en ce que le dissipateur de chaleur (1) se compose de la platine de montage (12) et d'ailettes ventilées parallèles (11) disposées sur un côté de ladite platine.

6. Ensemble selon l'une des revendications 1 à 4, caractérisé en ce que le dissipateur de chaleur (1) se compose de la platine de montage (12) et d'ailettes ventilées parallèles (11) disposées latéralement sur les deux côtés de ladite platine.

7. Ensemble selon la revendication 6, caractérisé en ce que les ailettes ventilées extrêmes (11) du dissipateur de chaleur (1) servent simultanément de parois latérales du canal d'air frais.

8. Ensemble selon l'une des revendications 1 à 7, caractérisé en ce que le dissipateur de chaleur (1) comporte à l'extrémité de chaque ailette ventilée extrême (11) une patte (14) avec des rebords.

9. Ensemble selon l'une des revendications 1 à 8, caractérisé en ce que la plaquette à circuits imprimés (7) est assemblée avec l'une ou avec les deux parois latérales (5) du canal d'air frais grâce à une articulation (8) et maintenue appuyée, par au moins un de ses bords, sur le chant de la paroi latérale correspondante, grâce à des clips.

10. Ensemble selon l'une des revendications 1 à 9, caractérisé en ce que la plaquette à circuits imprimés (7) est fixée par des vis avec la zone extrême (52) de configuration correspondante, de chaque paroi latérale (5).

11. Ensemble selon l'une des revendications 1 à 10, caractérisé en ce que la plaquette à circuits imprimés (7) est assemblée avec les parois latérales (5) par des moyens de fixation rapides, connus en soi, tels que des emboîtements à baïonnette, des verrouillages tournants, des arrêtoirs.

12. Ensemble selon l'une des revendications 1 à 11, caractérisé en ce que la plaquette à circuits imprimés (7) comporte sur sa face intérieure tous les conducteurs nécessaires au guidage et montage d'éléments de circuit supplémentaires.

13. Ensemble selon l'une des revendications 1 à 12, caractérisé en ce que tous les éléments de circuit produisant une déperdition calorifique sont disposés sur la face intérieure de la plaquette à circuits imprimés (7).

14. Ensemble selon l'une des revendications 1 à 13, caractérisé en ce que la plaquette à circuits primés (7) est pourvu, en vue de faciliter le contrôle du fonctionnement d'éléments de circuit, de boulons de contact traversant ladite plaquette (7), dont le côté intérieur est relié à des éléments de raccordement essentiels.

15. Ensemble selon l'une des revendications 1 à 14, caractérisé en ce que la plaquette à circuits imprimés (7) est construite, au moins sur un côté, de façon adaptée à la disposition d'éléments de circuits supplémentaires sur au moins une nappe de connexion située au dessus de ladite plaquette à circuits imprimés (7).